# NEUE EUROPÄISCHE PATENTSCHRIFT

(11) **EP 1 495 486 B3**
(45) Veröffentlichungstag dieser Patentschrift: **21.10.2009**
(45) Hinweis auf die Patenterteilung: 04.10.2006
(21) Anmeldenummer: 03720475.7
(22) Anmeldetag: 15.04.2003
(51) Int. Cl.: H01L 21/00

(54) **VERFAHREN UND VORRICHTUNG ZUR KONDITIONIERUNG VON HALBLEITERWAFERN UND/ODER HYBRIDEN**
METHOD AND DEVICE FOR CONDITIONING SEMICONDUCTOR WAFERS AND/OR HYBRIDS
PROCEDE ET DISPOSITIF POUR CONDITIONNER DES PLAQUETTES SEMI-CONDUCTRICES ET/OU DES HYBRIDES

(30) Priorität: 15.04.2002 DE 10216786
(43) Veröffentlichungstag der Anmeldung: 12.01.2005
(73) Patentinhaber: ERS electronic GmbH, 82110 Germering (DE)
(72) Erfinder: REITINGER, Erich, 80636 München (DE)
(74) Vertreter: Barth, Stephan Manuel
(86) Internationale Anmeldenummer: PCT/EP2003/003937
(87) Internationale Veröffentlichungsnummer: WO 2003/088323

(56) Entgegenhaltungen:
- WO-A-03/014411
- DE-U- 20 205 949
- US-A- 5 885 353
- US-A- 6 099 643

## Beschreibung

Die vorliegende Erfindung betrifft ein Verfahren und eine Vorrichtung zur Konditionierung von Halbleiterwafern und/oder Hybriden.

Bekannterweise werden Testmessungen an Halbleiterwafern typischerweise in einem Temperaturbereich zwischen -200°C und +400°C durchgeführt. Zur Temperierung wird ein Halbleiterwafer auf einen Probertisch gelegt, der entsprechend der Soll-Temperatur gekühlt und/oder beheizt wird. Dabei ist darauf zu achten, dass die Temperatur des Halbleiterwafers nicht unter den Taupunkt des umgebendengasförmigen Mediums gerät, da sonst eine Kondensation von Feuchtigkeit auf der Waferoberfläche bzw. eine Vereisung auftritt, welche die Testmessungen behindert bzw. unmöglich macht.

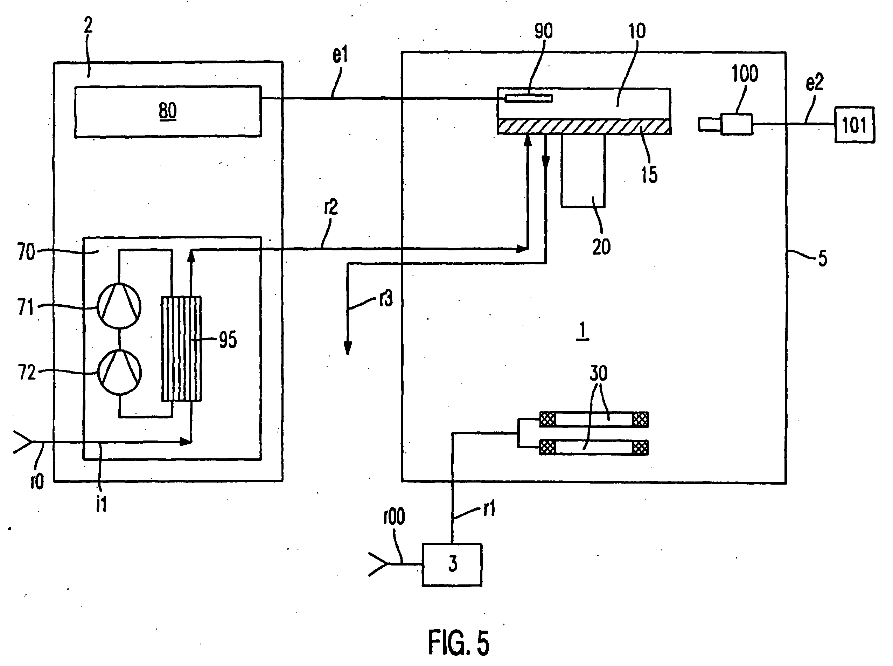

Fig. 5 zeigt eine schematische Querschnittsansicht einer Konditionierungsvorrichtung zur Erläuterung der Problematik, welche der vorliegenden Erfindung zugrunde liegt.

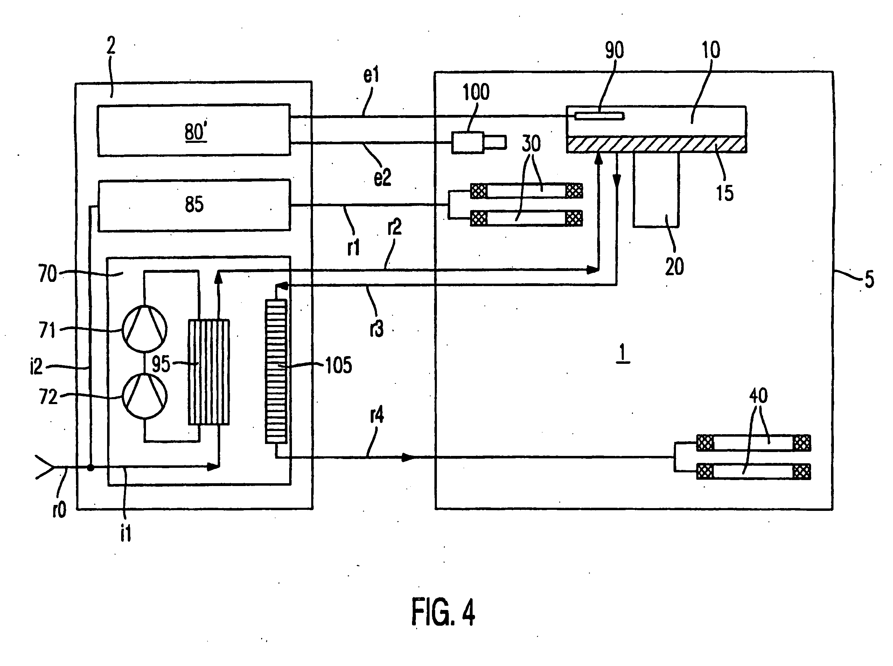

In Fig. 4 bezeichnet Bezugszeichen 1 einen Raum in einem Behälter 5. in dem ein temperierbarer Probertisch 10 vorgesehen ist, auf den (nicht gezeigter) ein Halbleiterwafer zu Testzwecken aufgelegt werden kann. Das Volumen des Behälters 5 liegt üblicherweise zwischen 400 und 800 Litern.

Der Raum 1 ist im wesentlichen durch die Wände des Behälters 5 geschlossen, welche Durchführungen für elektrische Leitungen und Medienversorgungsleitungensowieggf. Durchführungen für extern anzubringende Sonden aufweisen, mit denen dieTestmessungen gezeigten Halbleiterwafer durchzuführen sind. Der Raum 1 muss durch den Behälter 5 allerdings abhängig vom Anwendungsfall nicht hermetisch abgeschlossen sein, muss aberzumindest soweit geschlossen dass ein ungewünschtes Eindringen von feuchter Umgebungsluft durch Aufbau eines inneren überdrucks verhindert werden kann.

Der Probertisch 10 (auch Chuck genannt) weist eine thermische Isolation 15 auf, über die er mit einem üblicherweise beweglichen Fuß 20 verbunden ist. Ein entsprechender nicht gezeigter Bewegungsmechanismus weist in der Regel eine Verstellbarkeit In X-, Y- und Z-Richtung auf. Falls sich der Bewegungsmechanismus nicht in dem Behälter befindet, ist zwischen Fuß und Behälter eine Dichtung anzubringen.

Des weiteren ist in dem Probertisch 10 eine Heizeinrichtung 90 integriert, die von außen mit elektrischem Strom zum Heizen versorgt werden kann und die eine nicht gezeigte Temperatursonde aufweist.

Bezugszeichen 100 bezeichnet einen Taupunktsensor, mittels dem der Taupunkt innerhalb des Behälters 5 ermittelbar ist und die ein entsprechendes Signal nach außerhalb des Behälters 5 an einen Monitor 101 liefern kann. Der Taupunktsensor 100 dient insbesondere zur Sicherheit beim Offnen des Geräts, damit z.B. ein Gegenheizen erfolgen kann, um eine Betauung zu vermeiden.

Weiterhin vorgesehen im Behälter sind Ausströmelemente 30 (oBdA. sind nur zwei gezeigt), über die von außerhalb über eine Leitung r1 getrocknete Luft oder ein ähnliches Fluid, wie z.B. Stickstoff, in den Behälter eingeführt werden kann, um feuchte Umgebungsluft aus dem Behälter 5 auszutreiben. Diese Luft wird zunächst extern über eine Leitung r00 an einen Lufttrockner 3 zugeführt und dann in die Leitung r1 eingespeist.

Eine separate Einheit, welche mit dem Behälter 5 über eine entsprechende elektrische Leitungen 11 und eine Medienversorgungsleitung r2 verbunden ist, ist das Temporatursteuorrack 2, welches folgende Einrichtungen aufweist.

Mit Bezugszeichen 80 ist ein Temperatur-Controller bezeichnet, der durch Beheizen der Heizeinrichtung 90 die Temperatur des Probertisches 10 regeln kann, wobei der Probertisch 10 gleichzeitig oder alternativ mit Luft zur Kühlung durchspülbar ist, wie unten näher erläutert wird.

Bezugszeichen 70 bezeichnet eine Temperierungseinrichtung, der über die Leitungen r0 und i1 trokkene Luft z.B. aus einer Gasflasche oderauch aus einem Lufttrockner zugeführt wird und die einen Wärmetauscher 95 aufweist, der mit Kühlaggregaten 71. 72 verbunden ist, durch die er auf eine vorbestimmte Temperatur bringbar ist.

Die über die Leitungen r0, i1 zugeführte trockene Luft wird durch den Wärmetauscher 95 geleitet und anschließend über die Versorgungsleitung r2 In den Behälter 5 zum Probertisch 10 geführt, den sie durch entsprechende nichtgezeigte Kühlschlangen bzw. Kühlrohre durchquert Über die Leitung r3 verlässt die trockene Luft, welche den Probertisch 10 gekühlt hat, denselben und wird aus dem Behälter 5 heraus an die Atmosphäre geleitet.

Üblicherweise (siehe z.B US 5 885 353) wird die trockene Luft, welche zur Konditionierung derAtmosphäre in dem Behälter 5 über die Ausströmelemente 30 in den Behälter 1 geleitet wird, auf Raumtemperatur gehalten, so dass lediglich die Oberfläche des Probertisches 10 auf der gewünschten Messtemperatur, beispielsweise -20°C. gehalten wird, die übrigen Elemente in dem Behälter 5 jedoch ungefähr auf Raumtemperatur sind. Aus dem Behälter 5 heraus strömt diese über die Ausströmelemente 30 zugeführte trockene Luft durch nicht' gezeigte Ritzen bzw. Spalte oder eine separate Auslassleitung.

Als nachteilhaft bei dieser bekannten Vorrichtung zum Konditionieren von Halbleiterwafern hat sich die Tatsache herausgestellt, dass ein relativ hoher Verbrauch an getrockneter Luft auftritt, da diese einerseits zum Konditionieren der Atmosphäre und andererseits zum Kühlen des Probertisches 10 durch den Behälter 5 an die Atmosphäre geblasen wird. Somit ist der Verbrauch an getrockneter Luft relativ hoch. Auch bewirkt ein Ausfall des Lufttrorkners 3 ein sofortiges Vereisen des getesteten Wafers bei entsprechenden Temperaturen.

Daher ist es Aufgabe der vorliegenden Erfindung, ein Verfahren und eine Vorrichtung zur Konditionierung von Halbleiterwafern und/oder Hybriden anzugeben, welche eine effizientere Konditionierung ermöglichen.

Das erfindungsgemäße Verfahren mit den Merkmalen des Anspruchs 1 bzw, die entsprechende Vorrichtung nach Anspruch 5 weisen gegenüber dem bekannten Lösungsansatz den Vorteil auf, dass eine effiziente Ausnutzung des trockenen Gases möglich ist, beispielsweise der getrockneten Luft. Weitere Vorteile liegen in der hohen Betnebssicherung und in der Garantie derEisfreiheit bzw. Kondensationsfreiheit, da diedie Wafer/Hybrid-Aufnahmeeinrichtung verlassende trockene Luft stets unterhalb des Taupunktes der an der Waferl Hybrid-Aufnahmeeinrichtung anliegenden Temperatur ist.

Die der vorliegenden Erfindung zugrundeliegende Idee besteht darin, dass zumindest ein Teil des die Wafer/Hybrid-Aufnahmeeinrichtung verlassenden Gases zum Konditionieren der Atmosphäre innerhalb des Raums verwendet wird. Bei der vorliegenden Erfindung wird also Kühlluft gleichzeitig zumindest teilweise als Trockenluft verwendet. Es ist vorteilhaft, wenn der Teil des Gases zunächst temperiert wird und dann innerhalb des Raums ausströmen gelassen wird.

Z.B. wird der Teil außerhalb eines Behälters temperiert und dann dem Behälter wieder zugeführt. Ein besonderer Vorteil dieses Beispiels liegt darin, dass eine höhere Kühleffizienz durch eine entsprechende Rückführung der Luft vom Probertisch nach außerhalb des Behälters ermöglicht wird. Mit anderen Worten kann die rückgeführte gekühlte Luft zusätzlich entweder zur Vorkühlung der eingespeisten trockenen Luft oder zur Kühlung bestimmter Aggregate verwendet werden, und nicht nur zur Kühlung der Wafer/Hybrid-Aufnahmeeinrichtung.

Es ist aber auch zusätzlich möglich, dass ein Teil des Gases unmittelbar nach dem Verlassen des Probertischs innerhalb des Behälters ausströmen gelassen wird. Da ein direktes Ausströmenlassen nicht bei allen Temperaturen zweckmäßig ist, sollte ein entsprechendes Regulierventil für diesen Teil des Gases vorgesehen sein.

In den Unteransprüchen finden sichvorteilhafte Weiterbildungen und Verbesserungen des betreffenden Gegenstandes der Erfindung.

Erfindungsgemäß weist die Leitungseinrichtung eine erste Leitung, über die das Fluid von außerhalb des Raums in die Wafer/Hybrid-Aufnahmeeinrichtung leitbar ist, eine zweite Leitung, über die das Fluid aus der Wafer/Hybrid-Aufnahmeeinrichtung nach außerhalb des Raums leitbar ist, und eine dritte Leitung, über die das Fluid von außerhalb des Raums in den Raum rückführbar ist, auf. Zwischen der zweiten und dritten Leitung ist eine Temperierungseinrichtung vorgesehen.

Gemäss einer weiteren bevorzugten Weiterbildung sind am Ende derdritten Leitung Ausströmelemente vorgesehen.

Gemäss einer weiteren bevorzugten Weiterbildung ist ein Ventil zum strömungsmengenmäßigen Regulieren der vierten Leitung vorgesehen.

Gemäss einer weiteren bevorzugten Weiterbildung weist die Tempariarungseinrichtung eine Heizeinrichtung aufweist.

Erfindungsgemäß weist die Temperierungseinrichtung einen Wärmetauscher auf, dem zumindest ein Teil des den Raum verlassenden Fluids zuleitbar ist, wobei

der Wärmetauscher zum Vorkühlen des zugeführten Fluids dient, wobei

die Leitungseinrichtung derart gestaltet ist, dass der den Wärmetauscherverlassende Teil zumindest teilweise zum Konditionieren der Atmosphäre in den Raum rückführbar ist.

Gemäss einer weiteren bevorzugten Weiterbildung ist eine weitere Leitung vorgesehen ist, über die zusätzlich trockenes Fluid direkt von außerhalb des Raums in den Raum leitbar ist.

Erfindungsgemäß ist der Raum durch einen Behälter im wesentlichen geschlossen.

Ausführungsbeispiele der Erfindung sind in den Zeichnungen dargestellt und in der nachfolgenden Beschreibung näher erläutert.

Es zeigen:
- Fig. 1: eine schematische Darstellung einer ersten beispielhaften Konditionierungsvorrichtung:
- Fig. 2: eine schematische Darstellung einer zweiten beispielhaften Konditionierungsvorrichtung;
- Fig. 3: eine schematische Querschnittsansicht einer Ausführungsform der erfindungsgemä- ßen Konditionierungsvorrichtung;
- Fig. 4: eine schematische Querschnittsansicht einer vierten beispielhaften Konditionierungsvorrichtung; und
- Fig. 5: eine schematische Querschnittsansicht einer Kondittoniefungsvorrichtuna zur Erläuterung der Problematik, welche der vorliegenden Er- findung zugrunde liegt.

In den Figuren bezeichnen gleiche Bezugszeichen gleiche oder funktiansgleiche Bestandteile.

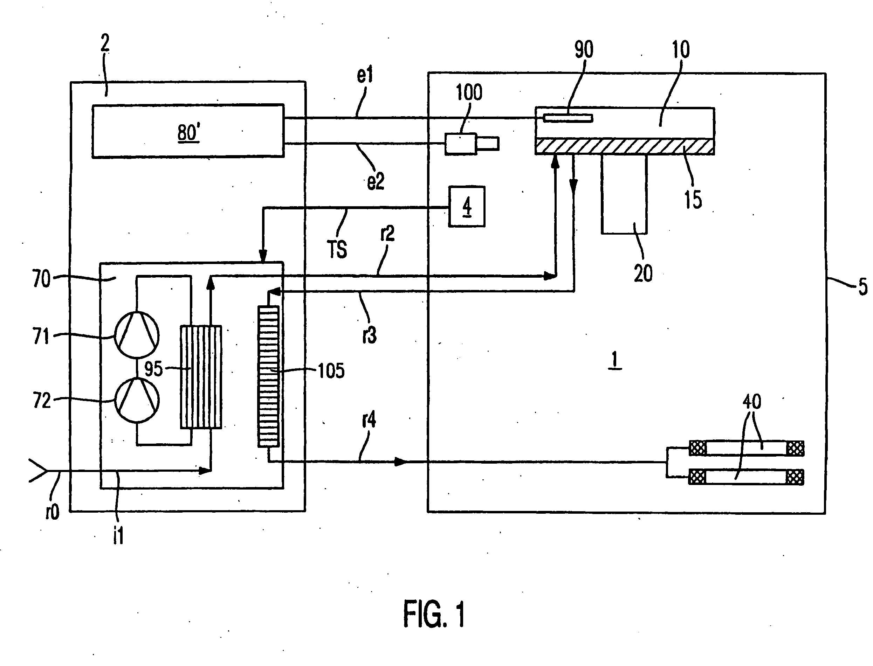

Fig. 1 zeigt eine schematische Darstellung einer ersten beispielhaften Konditionierungsvorrichtung.

Im folgenden werden zur Vermeidung von Wiederholungen Komponenten nicht erneut beschrieben, die bereits oben im Zusammenhang mit Fig. 5 beschrieben wurden.

Mit Bezugszeichen 80' ist ein modifizierter Temperatur-Controller bezeichnet, der nicht nur durch Beheizen der Heizeinrichtung 90 die Temperatur des Probertisches 10 regeln kann, sondern auch über eine Leitung 12 mit dem Taupunktsensor 100 gekoppelt ist und so ein automatisches Gegenheizen bei einer Betauungs-/ Vereisungsgefahr einleiten kann.

Gemäss Fig. 1 ist in der Temperierungseinrichtung 70 zusätzlich eine Heizeinrichtung 105 integriert, welche nicht in direktem Kontakt mit dem Wärmetauscher95 steht. Anstatt an der Umgebungsatmosphäre zu enden, ist die Leitung r3 zur Heizeinrichtung 105 geleitet, so dass die den Probertisch 10 verlassene trockene Luft gleichsam zum Temperatursteuerrack 2 zurückgeführt wird und nach Durchlaufen der Heinzeinrichtung 105 überdie Leitung r4 wieder zum Behälter 5 geleitet, in dem sie durch Ausströmelemente 40 zum Konditionieren der Atmosphäre in dem Raum 1 ausströmt.

Bezugszeichen 4 bezeichnet einen Temperatursensor zur Erfassung der Temperatur im Raum 1, der ein entsprechendes Temperatursignal TS an die Temperierungseinrichtung 70 liefert, welches zur Regelung der Temperatur mittels der Heizeinrichtung 105 verwendet wird.

Durch diese Anordnung kann die getrocknete Luft eine Doppelfunktion erfüllen, nämlich zuerstdie Kühlung des Probertisches 10 und danach die Konditionierung der Atmosphäre des Raums 1, bevor sie durch Offnungen des Behälter 5 wieder an die Umgebungsatmosphäre geführt wird, und somit effektiver verwendet werden.

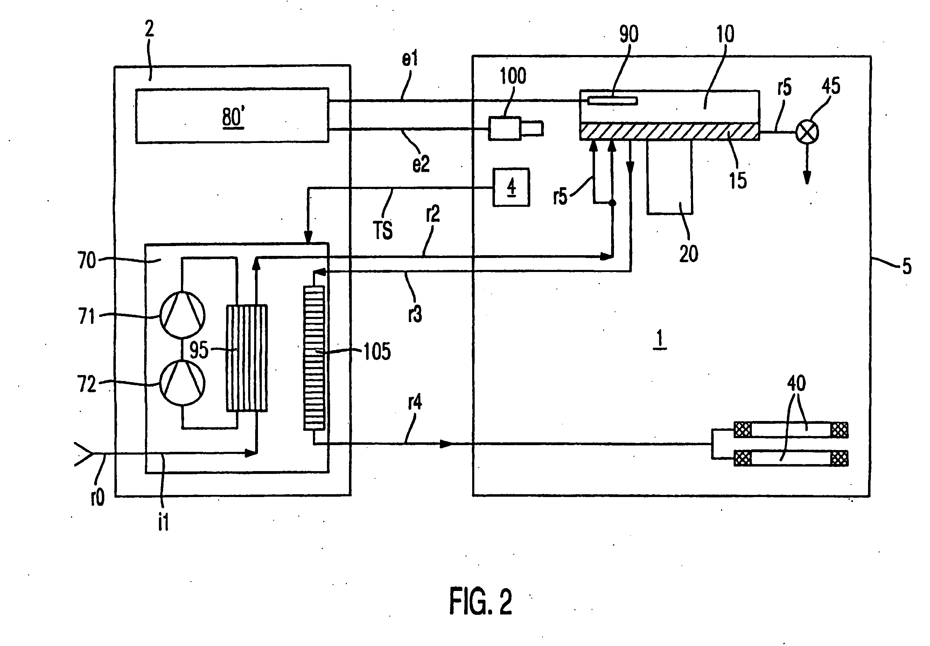

Fig. 2 zeigt eine schematiche Darstellung einer beispielhaften Konditionlerungsvorrichtung.

Gemäss Fig. 2 zweigt von der Leitung r2 unmittelbar vor dem Probertisch 10 eine Leitung r5 ab, weiche ebenfalls durch den Probertisch 10 in Form von einer Kühlschlange bzw. einem Kühlrohr geleitet wird, aber dann den Probertisch 10 an einer anderen Stelle verlässt als die Leitung r3 und von dort aus über ein steuerbares Auslassventil 45 die entsprechende getrocknete Luft direkt in den Behälter 5 nach dem Verlassen des Probertisches 10 leitet.

Da dies bei sehr tiefen Temperaturen bei bestimmten Anwendungen zu Problemen führen könnte, ist diese Option des Leitens des trockenen Gases über die Leitung r5 in den Behälter 1 durch das Auslassventil 45 regulierbar. Die Regulierung kann in üblicher Weise, beispielsweise ferngesteuert oder drahtgesteuert, erfolgen.

Ansonsten ist das zweite Beispiel gleich aufgebaut wie das oben beschriebene erste Beispiel.

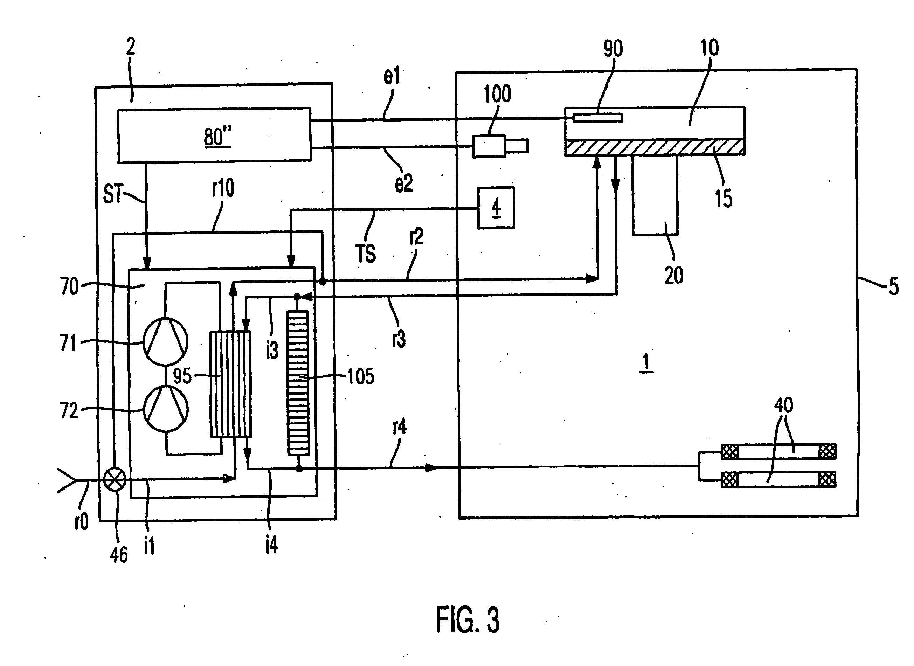

Fig. 3 zeigt eine schematische Querschnittsansicht einer Ausführungsform der erfindungsgemäßen Konditionierungsvorrichtung.

Mit Bezugszeichen 80' ist ein weiter modifizierter Temperatur-Controller bezeichnet, der auch die Temperierungseinrichtung 70 über die Steuerleitung ST steuert und somit die Rolle einer Zentraltemperatursteueru ng spielt.

Bei der dritten Ausführungsform gemäss Fig. 3 wird ein Teil der über die Leitung r3 zurückgeführten trokkenen Luft vor der Heizeinrichtung 105 über eine Leitung i3 abgezweigt und durch den Wärmetauscher 95 geleitet, wo sie genau so wie die frisch über die Leitungen r0, i1 zugeführte trockene Luft zur Abkühlung beiträgt. Den Wärmetauscher 95 verlässt die trockene Luft über die Leitung i4 und wird unmittelbar hinter der Heizeinrichtung 105 mit der Luft zusammengeführt, welche durch die Heizeinrichtung 105 geflossen ist. Vom entsprechenden Knotenpunkt wird diese trockene Luft genau wie bei der ersten Ausführungsform über die Leitung r4 und die Ausströmelemente 40 in den Behälter 5 zur Konditionierung dessen Atmosphäre geleitet.

Weiterhin sieht diese Ausführungsform ein steuerbares Mischventil 46 und eine Bypassleitung r10 vor, durch die der Wärmetauscher 95 umgangen werden kann.

Der besondere Vorteil bei dieser Ausführungsform ist, dass eine "Restkälte" der getrockneten Luft, welche vom Probertisch 10 zurückfließt, zur Abkühlung des Wärmetauschers genutzt werden kann und gleichzeitig erwärmt in den Behälter 5 zurückgeführt werden kann.

Ansonsten ist die Ausführungsform gleich aufgebaut wie das oben beschriebene erste Beispiel.

Fig. 4 zeigt eine schematische Querschnittsansicht einer beispielhaften Konditionierungsvorrichtung.

Bezugszeichen 85 In Fig. 4 bezeichnet einen zusätzlichen Gastemperatur-Controller, dem über Leitungen r0, i2 trockenes Gas, beispielsweise getrocknete Luft, von derselben Gasquelle wie derjenigen des Wärmetausches 95 zugeführt wird, welche dieser auf eine vorbestimmte Temperatur bringt und dann über die Leitung r1 über die Ausströmelemente 30 in das Innere des Behälters 5 leitet.

Die direkte Zuführung getrockneter Luft über die Ausströmelemente 30 in den Behälter 5 ist bei dieser Ausführungsform also noch zusätzlich vorgesehen, kann aber abschaltbar gestaltet werden, wenn die Durchflussmenge durch den Probertisch 10 vollständig zur Konditionierung der Atmosphäre innerhalb des Behälters 5 ausreicht.

## Patentansprüche

1. Verfahren zur Konditionierung von Halbleiterwafern und/oder Hybriden mit den Schritten:
Bereitstellen eines zumindest teilweise geschlossenen Raums (1) mit einer darin befindlichen Wafer/Hybrid-Aufnahmeeinrichtung (10) zur Aufnahme eines Halbleiterwafers und/oder Hybrids; und
Leiten eines trockenen Fluids durch die Wafer/Hybrid-Aufnahmeeinrichtung (10) zum Temperieren der Wafer/Hybrid-Aufnahmeeinrichtung (10);
wobei zumindest ein Teil des die Wafer/Hybrid-Aufnahmeeinrichtung (10) verlassenden Fluids zum Konditionieren der Atmosphäre innerhalb des Raums (1) verwendet wird;
wobei der Raum (1) durch einen Behälter (5) im Wesentlichen geschlossen ist;
wobei der Teil des die Wafer/Hybrid-Aufnahmevorrichtung (10) verlassenden Fluids zunächst temperiert wird und dann innerhalb des Raums (1) ausströmen gelassen wird; und
wobei der Teil des die Wafer/Hybrid-Aufnahmevorrichtung (10) verlassenden Fluids **dadurch** temperiert wird, dass er zur Vorkühlung des Fluids in einem Wärmetauscher außerhalb des Raums (1) verwendet wird, bevor er innerhalb des Raums (1) ausströmen gelassen wird.

2. Verfahren nach Anspruch 1, **dadurch gekennzeichnet, dass** der Teil des die wafer/Hybrid-Aufnahmevorrichtung (10) verlassenden Fluids außerhalb des Raums (1) temperiert wird und dann dem Raum (1) wieder zugeführt wird.

3. Verfahren nach Anspruch 1, **dadurch gekennzeichnet, dass** ein erster Teil des den Probertisch (10) verlassenden Fluids zunächst temperiert wird und dann innerhalb des Raums (1) ausströmen gelassen wird und ein zweiter Teil unmittelbar nach dem Verlassen der Wafer/Hybrid-Aufnahmeeinrichtung (10) innerhalb des Raums (1) ausströmen gelassen wird.

4. Verfahren nach Anspruch 3, **dadurch gekennzeichnet, dass** zumindest einer vom ersten und zweiten Teil strömungsmengenmäßig regulierbar ist.

5. Vorrichtung zur Konditionierung von Halbleiterwafern und/oder Hybriden mit:
einem zumindest teilweise geschlossenen Raum (1), wobei der Raum (1) durch einen Behälter (5) im Wesentlichen geschlossen ist, mit einer darin befindlichen wafer/Hybrid-Aufnahmeeinrichtung (10) zur Aufnahme eines Halbleiterwafers und/oder Hybrides; und
einer Leitungseinrichtung (r2, r3, r4, r5, i3, i4) zum Leiten eines trockenen Fluids durch die Wafer/Hybrid-Aufnahmeeinrichtung (10) zum Temperieren der Wafer/Hybrid-Aufnahmeeinrichtung (10) und zum Leiten zumindest eines Teiles des die wafer/Hybrid-Aufnahmeeinrichtung (10) verlassenden Fluids in den Raum (1) zum Konditionieren der. Atmosphäre in dem Raum (1);
wobei die Leitungseinrichtung (r2, r3, r4, r5, i3, i4) aufweist:
eine erste Leitung (r2), über die das Fluid von außerhalb des Raums (1) in die Mafer/Hybrid-Aufnahmeeinrichtung (10) leitbar ist;
eine zweite Leitung (r3), über die das Fluid aus der Wafer/Hybrid-Aufnahmeeinrichtung (10) nach außerhalb der Raums (1) leitbar ist; und
eine dritte Leitung (r4), über die das Fluid von außerhalb des Raums (1) in den Raum (1) rückführbar ist;
wobei zwischen der zweiten und dritten Leitung (r3, r4) eine Temperierungseinrichtung (70; 70, 80'') vorgesehen ist;
wobei die Temperierungseinrichtung (70; 70, 80'') einen Wärmetauscher (95) aufweist, dem zumindest ein Teil des den Raum (1) verlassenden Fluids zuleitbar ist;
wobei der Wärmetauscher (95) zum Vorkühlen des zugeführten Fluids dient;
wobei die Leitungseinrichtung (r2, r3, r4, r5, i3, i4) derart gestaltet ist, dass der den Wärmetauscher (95) verlassende Teil zumindest teilweise zum Konditionieren der Atmosphäre in den Raum rückführbar ist.

6. Vorrichtung nach Anspruch 5, **dadurch gekennzeichnet, dass** am Ende der dritten Leitung (r4) Ausströmelemente (40) vorgesehen sind.

7. Vorrichtung nach Anspruch 5, **dadurch gekennzeichnet, dass** die Leitungseinrichtung (r2, r3, r4, r5, i3, i4) aufweist:
eine vierte Leitung (r5), über die das Fluid aus der Wafer/Hybrid-Aufnahmeeinrichtung (10) in den Raum (1) leitbar ist.

8. Vorrichtung nach Anspruch 7, **dadurch gekennzeichnet, dass** ein Ventil (45) zum strömungsmengenmäßigen Regulieren der vierten Leitung (r5) vorgesehen ist.

9. Vorrichtung nach einem der Anspruche 5 bis 8, **dadurch gekennzeichnet, dass** die Temperierungseinrichtung (70; 70, 80'') eine Heizeinrichtung (105) aufweist.

10. Vorrichtung nach einem der Ansprüche 5 bis 9, **dadurch gekennzeichnet, dass** eine weitere Leitung (r1) vorgesehen ist, über die zusätzlich trockenes Fluid direkt von außerhalb des Raums (1) in den Raum (1) leitbar ist.

## Claims

1. Method for conditioning semiconductor wafers and/or hybrids comprising the steps:
preparation of a space (1) which is at least partially enclosed and has a wafer/hybrid holding device (10) which is located therein and has the purpose of holding a semiconductor wafer and/or hybrid; and
conduction of a dry fluid through the wafer/hybrid holding device (10) in order to temperature-regulate the wafer/hybrid holding device (10);
wherein at least a portion of the fluid leaving the wafer/hybrid holding device (10) is used to condition the atmosphere within the space (1);
wherein the space (1) is essentially enclosed by a container (5);
wherein the portion of the fluid leaving the wafer holding device (10) is firstly temperature-regulated and then allowed to flow out within the space (1); and
wherein the portion of the fluid leaving the wafer holding device (10) is temperature-regulated in that it is used for pre-cooling the fluid in a heat exchanger outside the space (1) before said portion is allowed to flow out within the space (1).

2. Method according to Claim 1, wherein the portion of the fluid leaving the wafer holding device (10) is temperature-regulated outside the space (1) and then fed back to the space (1).

3. Method according to Claim 1, wherein a first portion of the fluid leaving the sample stage (10) is firstly temperature-regulated and then allowed to flow out within the space (1), and a second portion is allowed to flow out within the space (1) directly after it leaves the wafer/hybrid holding device (10).

4. Method according to Claim 3, wherein at least one of the first and second portions can be flow-rate regulated.

5. Device for conditioning semiconductor wafers and/or hybrids comprising:
an at least partially enclosed space (1), the space (1) being essentially enclosed by a container (5), the space (1) having a wafer/hybrid holding device (10) which is located therein and has the purpose of holding a semiconductor wafer and/or hybrid; and a line device (r2, r3, r4, r5, i3, i4) for conducting a dry fluid through the wafer/hybrid holding device (10) for temperature-regulating the wafer/hybrid holding device (10) and for conducting at least a portion of the fluid leaving the wafer/hybrid holding device (10) into the space (1) for conditioning the atmosphere in the space (1);
wherein the line device (r2, r3, r4, r5, i3, i4) has:
a first line (r2) via which the fluid can be conducted into the wafer/hybrid holding device (10) from outside the space (1);
a second line (r3) via which the fluid can be conducted from the wafer/hybrid holding device (10) to outside the space (1); and
a third line (r4) via which the fluid can be fed back from outside the space (1) into the space (1);
wherein a temperature regulating device (70; 70, 80") is provided between the second and third lines (r3, r4);
wherein the temperature regulating device (70; 70, 80") has a heat exchanger (95) to which at least a portion of the fluid leaving the space (1) can be conducted;
wherein the heat exchanger (95) is used to pre-cool the fed-in fluid;
wherein the line device (r2, r3, r4, r5, i3, i4) is configured such that the portion leaving the heat exchanger (95) can be fed back at least partially into the space in order to condition the atmosphere.

6. Device according to Claim 5, wherein outflow elements (40) are provided at the end of the third line (r4).

7. Device according to Claim 5, wherein the line device (r2, r3, r4, r5, i3, i4) has:
a fourth line (r5) via which the fluid can be conducted from the wafer/hybrid holding device (10) into the space (1).

8. Device according to Claim 7, wherein a valve (45) is provided for regulating the flow rate of the fourth line (r5).

9. Device according to one of Claims 5 to 8, wherein the temperature regulating device (70; 70, 80") has a heating device (105).

10. Device according to one of Claims 5 to 9, wherein a further line (r1) is provided via which dry fluid can additionally be conducted directly into the space (1) from outside the space (1).

## Revendications

1. Procédé de conditionnement de plaquettes semi-conductrices et/ou d'hybrides avec les étapes suivantes :
préparer une pièce (1)fermée au moins partiellement avec un dispositif de logement de plaquette/ d'hybride (10) s'y trouvant pour loger une plaquette semi-conductrice et/ou un hybride ; et
conduire un fluide sec via le dispositif de logement de plaquette/ d'hybride (10) pour tempérer le dispositif de logement de plaquette/ d'hybride (10);
au moins une partie du fluide quittant le dispositif de logement de plaquette/ d'hybride (10) étant utilisée pour conditionner l'atmosphère à l'intérieur de la pièce (1);
la pièce (1) est essentiellement fermée par un récipient (5);
la partie du fluide quittant le dispositif de logement de plaquette/ d'hybride (10) étant d'abord tempérée et ensuite on la laisse circuler à l'intérieur de la pièce (1); et
la partie du fluide quittant le dispositif de logement de plaquette/ d'hybride (10) étant tempérée de telle façon qu'elle est utilisée à l'extérieur de la pièce (1) pour pré-refroidir le fluide dans un échangeur de chaleur, avant qu'on ne la laisse circuler à l'intérieur de la pièce (1).

2. Procédé selon la revendication 1, **caractérisé en ce que** la partie du fluide quittant le dispositif de logement de plaquette/ d'hybride (10) est tempérée en dehors de la pièce (1) et est ensuite retournée à nouveau dans la pièce (1).

3. Procédé selon la revendication 1, **caractérisé en ce qu'**une première partie du fluide quittant la table d'échantillonneur (10) est d'abord tempérée et **en ce qu'**on la laisse alors circuler a l'intérieur de la pièce (1) et **en ce qu'**on laisse une deuxième partie circuler à l'intérieur de la pièce (1) immédiatement après avoir quitté le dispositif de logement de plaquette/ d'hybride (10).

4. Procédé selon la revendication 3, **caractérisé en ce qu'**au moins l'une des première et deuxième parties peut être régulée en matière de quantité d'écoulement.

5. Dispositif de conditionnement de plaquettes semi-conductrices et/ou d'hybrides avec:
une pièce (1) fermée au moins partiellement, la pièce (1) est essentiellement fermée par un récipient (5), avec un dispositif de logement de plaquette/ d'hybride (10) s'y trouvant pour le logement d'une plaquette semi-conductrice et/ou un hybride ; et
un dispositif de guidage (r2, r3, r4, r5, i3, i4) pour conduire un fluide sec à travers le dispositif de logement de plaquette/ d'hybride (10) pour tempérer le dispositif de logement de plaquette/ d'hybride (10) et pour conduire au moins une partie du fluide quittant le dispositif de logement de plaquette/ d'hybride (10) dans la pièce (1) pour conditionner l'atmosphère dans la pièce (1);
le dispositif de guidage (r2, r3, r4, r5, i3, i4) comprenant:
une première conduite (r2) à travers laquelle le fluide peut être conduit de l'extérieur de la pièce (1) dans le dispositif de logement de plaquette/ d'hybride (10);
une deuxième conduite (r3) à travers laquelle le fluide peut être conduit du dispositif de logement de plaquette/ d'hybride (10) vers l'extérieur de la pièce (1); et
une troisième conduite (r4) à travers laquelle le fluide peut être reconduit dans la pièce (1) à partir de l'extérieur de la pièce (1),
un dispositif permettant de tempérer (70; 70, 80") étant agencé entre la deuxième et la troisième conduite (r3, r4);
le dispositif permettant de tempérer (70; 70, 80") comprenant un échangeur de chaleur (95) vers lequel au moins une partie du fluide quittant la pièce (1) peut être conduite;
l'échangeur de chaleur (95) servant à pré-refroidir le fluide amené;
le dispositif de guidage (r2, r3, r4, r5, i3, i4) présentant une forme telle que la partie quittant l'échangeur de chaleur (95) peut être reconduite au moins en partie afin de conditionner l'atmosphère dans la pièce.

6. Dispositif selon la revendication 5, **caractérisé en ce que** des éléments d'écoulement (40) sont prévus à l'extrémité de la troisième conduite (r4).

7. Dispositif selon la revendication 5, **caractérisé en ce que** le dispositif de guidage (r2, r3, r4, r5, i3, i4) comprend :
une quatrième conduite (r5) à travers laquelle le fluide peut être conduit à partir du dispositif de logement de plaquette/ d'hybride (10) dans la pièce (1).

8. Dispositif selon la revendication 7, **caractérisé en ce qu'**une soupape (45) est prévue pour réguler la quantité d'écoulement de la quatrième conduite (r5).

9. Dispositif selon l'une des revendications 5 à 8, **caractérisé en ce** le dispositif permettant de tempérer (70; 70, 80") comprend un dispositif de chauffage (105).

10. Dispositif selon l'une des revendications 5 à 9, **caractérisé en ce qu'**une autre conduite (r1) est prévue, à travers laquelle, de plus, du fluide sec peut être conduit directement à partir de l'extérieur de la pièce (1) dans la pièce (1).
